# EUROPÄISCHE PATENTSCHRIFT

(11) **EP 0 776 041 B1**
(45) Veröffentlichungstag und Bekanntmachung des Hinweises auf die Patenterteilung: **10.10.2007**
(21) Anmeldenummer: 96118608.7
(22) Anmeldetag: 19.11.1996
(51) Int. Cl.: H01L 25/07, H01L 23/495

(54) **Leistungs-Halbleitermodul**
Semiconductor power module
Module semi-conducteur de puissance

(30) Priorität: 24.11.1995 DE 19543920
(43) Veröffentlichungstag der Anmeldung: 28.05.1997
(73) Patentinhaber: Infineon Technologies AG, 81669 München (DE)
(72) Erfinder: Kuhnert, Reinhold, Dr., 96049 Bamberg (DE); Liebsch, Andreas, 24796 Bovenau (DE)
(74) Vertreter: Patentanwälte Westphal, Mussgnug & Partner

(56) Entgegenhaltungen:
- EP-A- 0 399 447
- CH-A- 681 185
- DE-A- 2 819 327
- US-A- 5 290 624
- US-A- 5 448 105
- PATENT ABSTRACTS OF JAPAN vol. 016, no. 104 (E-1178), 13. März 1992 & JP 03 280453 A (SEIKO EPSON CORP), 11. Dezember 1991

## Beschreibung

Die Erfindung betrifft ein Leistungshalbleitermodul mit den Merkmalen:
a) einer metallenen Basisplatte,
b) mit Halbleiterchips, die thermisch mit der Basisplatte verbunden und elektrisch gegen sie isoliert sind,
c) mit Anschlussleitungen, die die Halbleiterchips kontaktieren und elektrisch mit Gehäuseanschlüssen verbinden,
d) einem Gehäuse.

Solche Leistungshalbleiter-Module sind Stand der Technik und unter anderem z.B. in der EP 0 584 668 beschrieben worden. Die Halbleiterchips sind hier auf Leitungsbahnen gelötet, die auf einer Keramikplatte aufgebracht sind. Die Keramikplatte ihrerseits hat auf ihrer von den Leitungsbahnen abgekehrten Seite eine Metallisierung, mit der sie auf der Basisplatte z.B. durch Verlöten befestigt ist.

Die mit Leitungsbahnen beschichtete Keramik ist allgemein als DCB-Keramik bekannt. Diese DCB-Keramik ist jedoch für Massenprodukte und insbesondere für Niederspannungs-Anwendungen zu teuer.

In der US 5,448,105 ist ein Halbleiterbauelement beschrieben, bei dem ein Rahmen zur Kontaktierung des Halbleiterchips lediglich punktuell über eine Harzschicht mit einem Metallsubstrat verbunden ist. In der CH 681 185 A5 ist ein Verfahren zur Verbindung eines mit integrierten Schaltungen versehenen flächigen Bauelements mit einem Systemträger beschrieben. Die Mitte des Systemträgers bleibt, wie bei dem Rahmen zur Kontaktierung, der in US 5,448,105 beschrieben ist, von Material ausgespart. Die Halbleiterelemente sind in CH 681 185 A5 über ein Substrat mit dem Systemträger verbunden wobei ein unmittelbarer Kontakt des Systemträgers zu den Halbleiterelementen nicht hergestellt wird. Die Halbleiterchips können zudem mit ihren Unterseiten keinen unmittelbaren elektrischen Kontakt zu dem Systemträger herstellen.

Der Erfindung liegt die Aufgabe zugrunde, ein Leistungshalbleiter-Modul der oben angegebenen Gattung so weiterzubilden, dass bei ausreichender thermischer Kopplung der Halbleiterchips zu der Basisplatte zum Aufbau keine DCB-Keramik erforderlich ist. Diese Aufgabe wird gelöst durch die Merkmale:
e) Die Halbleiterchips sind aus einem aus Blech bestehenden Leitungssystem montiert und die Unterseiten der Halbleiterchips sind vollflächig elektrisch und thermisch mit diesem verbunden,
f) das Leitungssystem ist über eine beidseitig klebende isolierende Folie auf der Basisplatte befestigt,
g) die Unterseiten der Halbleiterchips sind vollflächig über die beidseitig klebende, isolierende Folie auf der Basisplatte befestigt.

Weiterbildungen der Erfindung sind Gegenstand der Unteransprüche.

Die Erfindung wird anhand einiger Ausführungsbeispiele in Verbindung mit den Figuren 1 bis 5 näher erläutert. Es zeigen
- Figur 1: die Aufsicht auf ein aus Blech bestehendes Leitungssystem (Leadframe) mit montierten Halbleiterchips,
- Figur 2 und 3: die Seitenansichten zweier Ausführungsbeispiele,
- Figur 4: die Aufsicht auf ein Modul mit zwei Halbleiterchips und
- Figur 5: die Seitenansicht auf ein weiteres Ausführungsbeispiel.

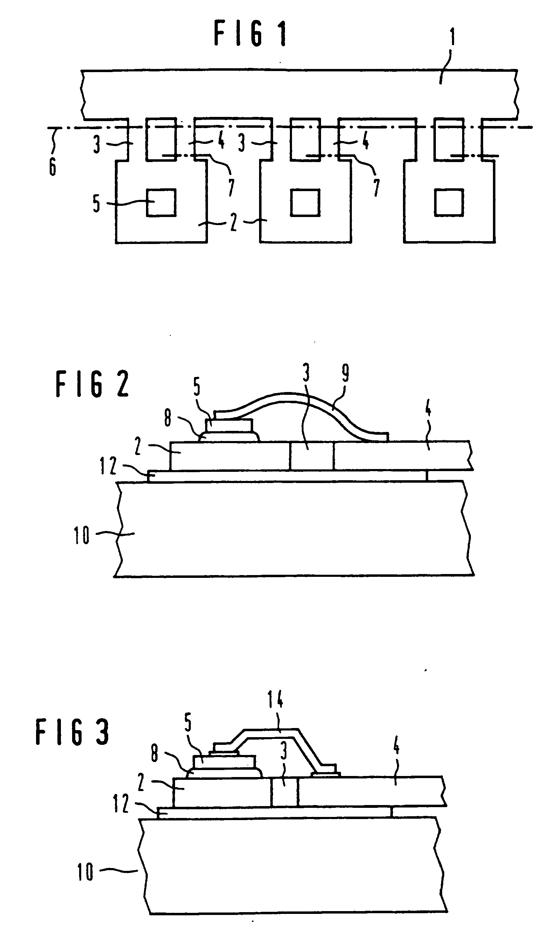

In Figur 1 ist ein aus Blech bestehendes Leitungssystem (Leadframe) dargestellt. Es enthält ein Band 1, mit dem über Verbindungsstege 3, 4 eine Vielzahl von Montageflächen 2 verbunden sind. Solche Leitungssysteme werden für die rationelle und automatische Herstellung von Halbleiterbauelementen in hohen Stückzahlen verwendet. Auf den Montageflächen 2 sind Halbleiterchips 5 z.B. durch Löten befestigt. Eine Anschlußleitung für das Halbleiterchip 5 wird durch den Steg 3 gebildet, die andere Anschlußleitung durch den Steg 4. Dazu wird der Steg 4 entlang der gestrichelten Linie 7 von der Montagefläche abgetrennt und zwischen dem Steg 4 und der Oberseite der Halbleiterchips 5 wird z.B. eine Bondverbindung hergestellt. Nach dem Umpressen mit Kunststoff werden die Stege 3, 4 entlang der gestrichelten Linie 6 vom Band 1 getrennt. Die Stege bilden dann die Gehäuseanschlüsse.

Das in Verbindung mit Figur 1 beschriebene bekannte Herstellverfahren für Einzel-Halbleiterbauelemente läßt sich gemäß für Module anwenden. Dazu werden mehrere Montageflächen 2 mit einer oder mehreren beidseitig klebenden, isolierenden Folien 12 mit einer Basisplatte 10 verklebt. Dies ist in Figur 2 dargestellt. Die beidseitig klebende, isolierende Folie 12 hält sowohl die Montageflächen 2 als auch den Verbindungssteg 3 und den von der Montagefläche 2 abgetrennten Steg 4 auf der Basisplatte fest. Dazu werden die genannten Teile auf die Klebefolie 12 gedrückt. Die Unterseite der Halbleiterchips 5 ist elektrisch und mechanisch z.B. über eine Lotschicht 8 mit der Montagefläche verbunden. Die Oberseite ist über einen Bonddraht 9 mit dem Steg 4 verbunden.

In Figur 3 ist dargestellt, daß die Oberseite des Halbleiterchips 5 mit dem Steg 4 durch eine Metallbrücke 14 verbunden ist. Diese Metallbrücke ist jeweils mit der Oberseite des Halbleiterchips 5 und mit dem Steg 4 z.B. durch Verlöten verbunden.

Die Leistungshalbleiter-Module enthalten mehrere Halbleiterchips. Diese können auf separaten Montageflächen angeordnet sein. Falls die Halbleiterchips mit der Unterseite auf gleichem Potential liegen dürfen, ist es auch möglich, mehrere der Halbleiterchips auf einer gemeinsamen Montagefläche anzuordnen und dort thermisch und elektrisch leitend zu befestigen. Die Leitungssysteme bestehen üblicherweise aus verzinntem Kupfer. Andere, gut wärmeleitenden Metalle sind jedoch ebenfalls möglich.

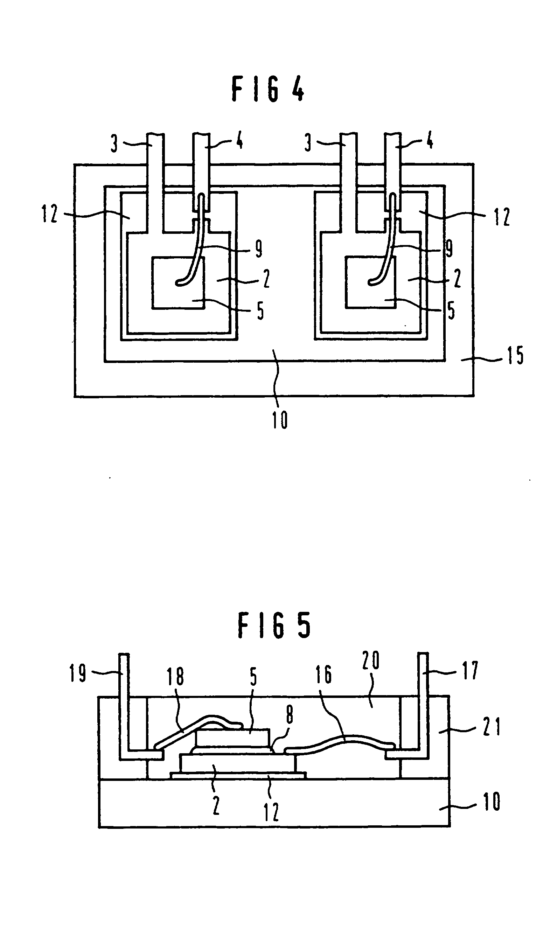

In Figur 4 ist die Aufsicht auf ein Leistungshalbleiter-Modul gezeigt, das aus zwei Einzelschaltern aufgebaut ist. Diese bestehen jeweils aus einem Halbleiterchip und werden jeweils über eine Klebefolie 12 mit einer einzigen Basisplatte 10 verklebt. Die beiden Anschlüsse 3, 4 jedes Schalters sind durch ein Kunststoffgehäuse 15 nach außen geführt. Der besseren Übersichtlichkeit halber ist hier nur der Umriß des Kunststoffgehäuses dargestellt. Selbstverständlich ist das Leistungshalbleiter-Modul auf der Oberfläche vom Kunststoff bedeckt. Die Unterseite des Moduls ist zweckmäßigerweise nicht vom Kunststoff bedeckt, hier bildet die Basisplatte 10 das Gehäuse. Das Modul kann dann mit der Basisplatte 10 auf einem Kühlkörper befestigt werden. Nach dem Umpressen werden die Anschlußleiter 3, 4 vom Band 1 abgetrennt.

Das Leistungshalbleiter-Modul kann beispielsweise auch als Halbbrücke, als Vollbrücke, als Parallelschaltung mehrerer Einzelschalter usw. ausgebildet sein. Hier variiert der innere Aufbau von Fall zu Fall. In allen Ausführungsformen werden jedoch mindestens die Montageflächen 2 über die erwähnte Folie mit der Basisplatte thermisch leitend verklebt.

Die Gehäuseanschlüsse müssen nicht notwendigerweise durch aus Blech bestehende Leitungssysteme (Leadframe) gebildet werden, sie können z.B. auch zum Einstecken in eine gedruckte Schaltung geeignete Stifte sein. In Figur 5 ist ein solches Ausführungsbeispiel gezeigt. Hier ist wieder ein Halbleiterchip 5 über eine Lotschicht 8 mit einem aus Blech bestehenden Leitungssystem 2 verlötet. Das Leitungssystem 2 ist über die doppelseitig klebende isolierende Folie 12 mit der Basisplatte verbunden. Auf der Basisplatte 10 sitzt ein isolierender Rahmen 21, in den L-förmige Leiter 17, 19 eingespritzt sind. Die Oberseite des Halbleiterchips 5 ist zu einem Bonddraht 18 mit dem Gehäuseanschluß 19 verbunden, die Unterseite über einen Bonddraht 16 mit dem Gehäuseanschluß 17. Die erzeugte Wärme fließt hier durch das Leitungssystem 2 und die isolierende Folie 12 zur Basisplatte 10 ab. Das Modul ist dann bis zur Höhe des Rahmens 21 z.B. mit einer plastischen Isoliermasse 20 vergossen.

Module mit komplexeren Verschaltungen können auch aus mehreren Leitungssystemen aufgebaut sein. Diese werden wie beschrieben durch eine oder mehrere doppelseitig klebende, isolierende Folien auf die Basisplatte geklebt und wie beschrieben mit den Halbleiterchips verbunden.

## Patentansprüche

1. Leistungshalbleiter-Modul mit
einer metallenen Basisplatte, mit Halbleiterchips, die thermisch mit der Basisplatte verbunden und elektrisch gegen sie isoliert sind, mit Anschlussleitungen, die die Halbleiterchips kontaktieren und elektrisch mit Gehäuseanschlüssen verbinden, und einem Gehäuse,
**dadurch gekennzeichnet, dass**
die Halbleiterchips (5) auf einem aus Blech bestehenden Leitungssystem (2, 3, 4) montiert und die Unterseiten der Halbleiterchips (5) vollflächig elektrisch und thermisch mit diesem verbunden sind, und
das Leitungssystem über eine beidseitig klebende, isolierende Folie (12) auf der Basisplatte (10) befestigt ist, wobei die Unterseiten der Halbleiterchips (5) vollflächig über die beidseitig klebende, isolierende Folie (12) auf der Basisplatte (10) befestigt sind.

2. Leistungshalbleiter-Modul nach Anspruch 1, bei dem die Anschlussleitungen aus Blech bestehen und über eine beidseitig klebende isolierende Folie (12) auf der Basisplatte (10) befestigt sind.

3. Leistungshalbleiter-Modul nach Anspruch 2, bei dem die Anschlussleitungen (3, 4) auch die Gehäuseanschlüsse bilden.

4. Leistungshalbleiter-Modul nach Anspruch 3, bei dem die Anschlussleitungen durch ein weiteres, aus Blech bestehendes Leitungssystem gebildet sind.

5. Leistungshalbleiter-Modul nach einem der Ansprüche 1 bis 3, bei dem die Anschlussleitungen mit den Halbleiterchips durch Bonddrähte (9) verbunden sind.

6. Leistungshalbleiter-Modul nach einem der Ansprüche 1 bis 3, bei dem die Anschlussleitungen mit den Halbleiterchips durch Metallbrücken (14) verbunden sind.

## Claims

1. Power semiconductor module comprising
a metallic baseplate, comprising semiconductor chips which are thermally connected to the baseplate and are electrically insulated from it, comprising connection lines which make contact with the semiconductor chips and electrically connect them to housing connections, and a housing,
**characterized in that**
the semiconductor chips (5) are mounted on a leadframe (2, 3, 4) composed of sheet metal and the undersides of the semiconductor chips (5) are electrically and thermally connected to said leadframe over the whole area, and
the leadframe is fixed on the baseplate (10) by means of a double-sided adhesive insulating film (12), the undersides of the semiconductor chips (5) being fixed on the baseplate (10) over the whole area by means of the double-sided adhesive insulating film (12).

2. Power semiconductor module according to Claim 1, in which the connection lines are composed of sheet metal and are fixed on the baseplate (10) by means of a double-sided adhesive insulating film (12).

3. Power semiconductor module according to Claim 2, in which the connection lines (3, 4) also form the housing connections.

4. Power semiconductor module according to Claim 3, in which the connection lines are formed by a further leadframe composed of sheet metal.

5. Power semiconductor module according to one of Claims 1 to 3, in which the connection lines are connected to the semiconductor chips by bonding wires (9).

6. Power semiconductor module according to one of Claims 1 to 3, in which the connection lines are connected to the semiconductor chips by metal bridges (14).

## Revendications

1. Module semi-conducteur de puissance comportant une plaque de base, métallique, des puces semi-conductrices reliées thermiquement à la plaque de base mais isolées électriquement par rapport à celle-ci, des lignes de branchement en contact avec les puces semi-conductrices et reliées électriquement aux branchements du boîtier, ainsi qu'un boîtier,
**caractérisé en ce que**
les puces semi-conductrices (5) sont installées sur un système de conducteurs (2, 3, 4) en tôle et les faces inférieures des puces semi-conductrices (5) sont reliées sur toute leur surface, électriquement et thermiquement à ce système et
le système de conducteurs est fixé à la plaque de base (10) par un film (12) isolant, adhésif double face, les faces inférieures des puces semi-conductrices (5) étant fixées sur toute leur surface sur la plaque de base (10) par le film isolant (12) adhésif, double face.

2. Module semi-conducteur de puissance selon la revendication 1, dont les lignes de branchement en tôle, sont fixées à la plaque de base (10) par un film isolant (12) adhésif double face.

3. Module semi-conducteur de puissance selon la revendication 2, dans lequel les lignes de branchement (3, 4) forment également les branchements du boîtier.

4. Module semi-conducteur de puissance selon la revendication 3, dans lequel les lignes de branchement sont formées par un autre système de conducteurs en tôle.

5. Module semi-conducteur de puissance selon l'une des revendications 1 à 3, dans lequel les lignes de branchement sont reliées aux puces semi-conductrices par des fils de liaison (9).

6. Module semi-conducteur de puissance selon l'une des revendications 1 à 3, dans lequel les lignes de branchement sont reliées aux puces semi-conductrices par des ponts métalliques (14).
